# EUROPEAN PATENT APPLICATION

(11) **EP 1 020 814 A2**
(43) Date of publication of application: **19.07.2000**
(21) Application number: 00100051.2
(22) Date of filing: 05.01.2000
(51) Int. Cl.: G06K 19/077

(54) **Process for producing non-contact data carrier**

(30) Priority: 14.01.1999 JP 769899
(71) Applicant: LINTEC Corporation, Tokyo 173-0001 (JP)
(72) Inventor: Nakata, Yasukazu, Matsudo-shi, Chiba 271-0044 (JP); Taguchi, Katsuhisa, Koshigaya-shi, Saitama 343-0841 (JP); Ichikawa, Akira, Urawa-shi, Saitama 338-0802 (JP)
(74) Representative: Schippan, Ralph, Dr.-Ing.

(57) **Abstract**

Disclosed is a process for producing a non-contact data carrier comprising the steps of:
(1) forming a laminate containing a substrate film, a non-contact data carrier element mounted on one surface of the substrate film, a photo-curable resin composition layer formed to cover a whole of the non-contact data carrier element, and a transparent film covering the photo-curable resin composition layer, the transparent film being peelable from a cured resin layer formed by curing the photo-curable resin composition;
(2) irradiating the photo-curable resin composition with a light capable of curing the photo-curable resin composition through the transparent film on said photo-curable resin composition layer, to thereby cure the photo-curable resin composition, and form said cured resin layer embedding the whole of the non-contact data carrier element;
(3) peeling the transparent film from the cured resin layer; and
(4) laminating a cover film to the cured resin layer.

## Description

### BACKGROUND OF THE INVENTION

### 1. Field of the Invention

The present invention relates to a process for producing a non-contact data carrier or a radio frequency identification card. The process of the present invention is suitable for producing a thin resin-sealed non-contact data carrier.

### 2. Description of the Related Art

A non-contact data carrier system is now in general use. This system includes a data carrier and an interrogator, and a data transmission is made without contact therebetween. The non-contact data carrier system is applied to, for example, commuting tickets of various transportation facilities, or for entrance and exit controls in various facilities or companies. In entrance and exit controls, a resin-sealed non-contact data carrier is generally used. This has brought about a further miniaturization of the device and in particular a thinner device.

A resin-sealed non-contact data carrier is produced by forming a non-contact data carrier element generally containing an antenna circuit, an IC chip, and optionally, other electronic components such as a condenser or a battery, on one side of a substrate film, and sealing the non-contact data carrier element with a thermoplastic resin or a thermosetting resin. In production, the non-contact data carrier element must not be broken, and a surface of the sealed-resin layer must not be affected by an irregular or uneven structure formed from a combination of a flat substrate film and the non-contact data carrier element mounted thereon.

For example, when a resin with a high viscosity is used, depressed portions of the irregular or uneven structure are not filled with the resin, and thus voids exist between the sealed resin and the non-contact data carrier element. Such voids may cause cracking or peeling. If the resin is forced into the depressed portions, there occurs a risk of breaking the non-contact data carrier element.

When a thermoplastic resin is used as the sealing resin, the sealed resin layer must be thicker, to ensure that the surface of the sealed resin layer is not affected by the irregular or uneven structure derived from the non-contact data carrier element. Therefore, a thermoplastic resin is not suitable for obtaining a thinner non-contact data carrier. Further, when a thermosetting resin is used as the sealing resin, it is necessary to apply heat upon curing, and therefore, a material having a low thermal resistance cannot be used. Further, in a non-contact data carrier containing a built-in battery, a liquid leakage from or a bursting of the battery may sometimes occur.

### SUMMARY OF THE INVENTION

Accordingly, the object of the present invention is to provide a process which enables the production of a thin non-contact data carrier; without a breakage of the non-contact data carrier element upon the coating or sealing thereof with a resin; without an affect on the surface of the sealed resin layer by an irregular or uneven structure formed from a combination of the flat substrate film and the non-contact data carrier element mounted thereon; and without a heating step.

Other objects and advantages of the present invention will be apparent from the following description.

In accordance with the present invention, there is provided a process for producing a non-contact data carrier comprising the steps of:
(1) forming a laminate containing a substrate film, a non-contact data carrier element mounted on one surface of the substrate film, a photo-curable resin composition layer formed to cover a whole of the non-contact data carrier element, and a transparent film covering the photo-curable resin composition layer, the transparent film being peelable from a cured resin layer formed by curing the photo-curable resin composition;
(2) irradiating the photo-curable resin composition with a light capable of curing the photo-curable resin composition through the transparent film on the photo-curable resin composition layer, to thereby cure the photo-curable resin composition and form the cured resin layer in which the whole of the non-contact data carrier element is embedded;
(3) peeling the transparent film from the cured resin layer; and
(4) laminating a cover film onto the cured resin layer.

In a preferable embodiment of the present invention, a viscosity of the photo-curable resin composition (before curing) is 5000 mPa·s or less.

In another preferable embodiment of the present invention, an adhesiveness of the cured resin formed by curing the photo-curable resin composition is 0.5 N/25 mm or more.

### BRIEF DESCRIPTION OF DRAWINGS

Figure 1 is a sectional view schematically illustrating a stage where a non-contact data carrier element is formed on one surface of a substrate film.

Figure 2 is a sectional view schematically illustrating a stage where a photo-curable resin composition is applied as a droplet to the substrate film of Fig. 1, on the surface carrying the non-contact data carrier element.

Figure 3 is a sectional view schematically illustrating a stage where a transparent film is placed on the photo-curable resin composition of Fig. 2, the photo-curable resin composition is spread to form a layer, and thereafter, the photo-curable resin composition is cured to form a cured resin layer.

Figure 4 is a sectional view schematically illustrating a stage wherein a transparent film is peeled from a surface of the cured resin layer of Fig. 3.

Figure 5 is a sectional view schematically illustrating a stage where, after the transparent film is peeled, a cover film is laminated to the cured resin layer.

### DESCRIPTION OF THE PREFERRED EMBODIMENTS

The above step (1) in the process of the present invention may comprise, for example, the steps of:
(1a-1) coating the surface of the substrate film with the photo-curable resin composition to cover the whole non-contact data carrier element therewith, whereby the photo-curable resin composition layer is formed; and then
(1a-2) laminating the transparent film onto the photo-curable resin composition layer, or
(1b-1) coating the transparent film with the photo-curable resin composition; and then
(1b-2) laminating the transparent film on the surface of the substrate film so that the whole non-contact data carrier element is covered with the photo-curable resin composition on the transparent film.

Referring to the accompanying drawings, a particular embodiment of the present invention will be described hereinafter.

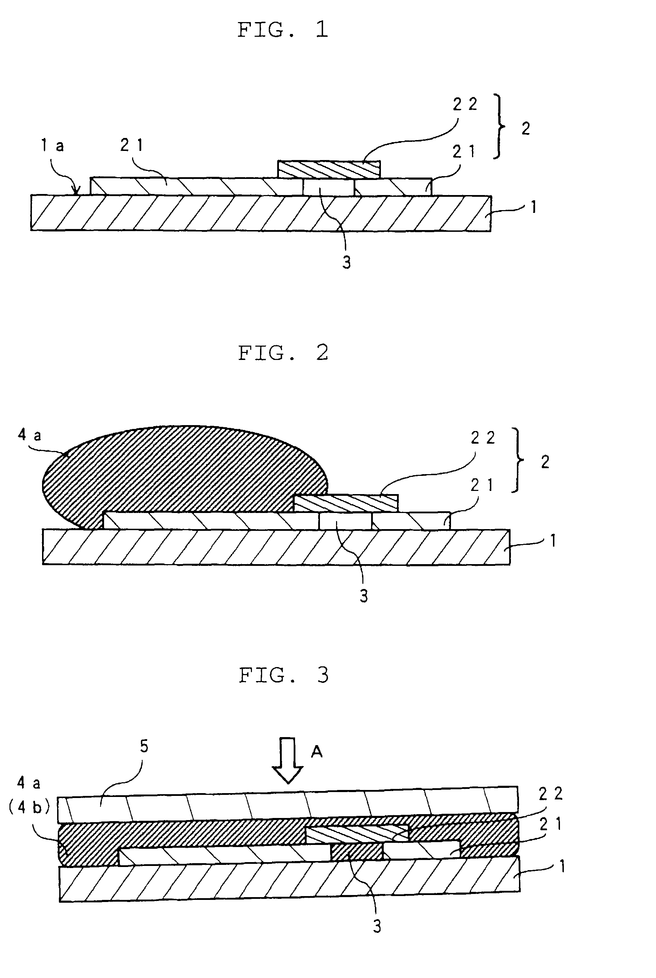

Figure 1 is a sectional view schematically illustrating a stage where a non-contact data carrier element 2 is formed on one surface la of a substrate film 1. The non-contact data carrier element 2 as shown in Fig. 1 contains an antenna circuit 21 and an IC chip 22 connected thereto. On the surface la of the substrate film 1, an irregular or uneven structure is formed which includes a protruded portion due to the antenna circuit 21, a protruded portion due to the IC chip 22 mounted on the antenna circuit 21, and depressed portions formed between the antenna circuit 21 and the IC chip 22.

The non-contact data carrier element may be composed of the antenna circuit and the IC chip, but may further contain other electronic components, such as a battery, a capacitor, a resistor, a coil, a diode, a connective circult or the like. The non-contact data carrier element may be formed on one surface of the substrate film by any method known per se. For example, a circuit, such as the antenna circuit, may be formed by printing, etching, or sputtering on one surface of the substrate film 1. Further, an IC chip, a battery, or a capacitor may be fixed or connected to the antenna circuit or to each other, with a solder or an electrically conductive resin to form the non-contact data carrier element.

Figure 2 is a sectional view schematically illustrating a stage where a photo-curable resin composition 4a is applied as a droplet to the substrate film 1, on the surface la carrying the non-contact data carrier element 2. Then, the transparent film 5 is laminated on the photo-curable resin composition 4a, and the transparent film 5 is lightly pushed in the direction of the surface la of the substrate film 1 to spread the photo-curable resin composition 4a on the surface la and cover the whole non-contact data carrier element 2, as shown in Fig. 3.

The photo-curable resin composition 4a has a viscosity sufficient to enable it to pour into and fill in the insides of the depressed portions. Therefore, as shown in Fig. 3, the photo-curable resin composition 4a enters deep to insides of the depressed portions 3 on the surface la, and these insides are completely filled with the photo-curable resin composition 4a. As a result, an entire surface of the non-contact data carrier element 2, including the protruded portions and the depressed portions thereof, are in close contact with the photo-curable resin composition 4a and thus protected thereby. It is sufficient that the photo-curable resin composition 4a completely covers the whole of the non-contact data carrier element 2, but preferably the photo-curable resin composition 4a covers the whole of the surface la.

As above, a laminate composed of the substrate film 1, the photo-curable resin composition layer 4a containing the non-contact data carrier element 2, and the transparent film 5 is obtained, as shown in Fig. 3.

In the process of the present invention, the process for forming the laminate is not limited, so long as the laminate as shown in Fig. 3 is produced. For example, the photo-curable resin composition may be applied to the surface carrying the non-contact data carrier element on the substrate film, then pressed and spread to thereby cover the whole non-contact data carrier element, and thereafter the transparent film laminated thereon.

Alternatively, one side of the transparent film may be coated with the photo-curable resin composition in the first place, and then laminated with the substrate film so that the surface carrying the photo-curable resin composition is brought into contact with the surface carrying the non-contact data carrier element, whereby the non-contact data carrier element may be completely covered with the photo-curable resin composition.

Subsequently, the photo-curable resin composition in the laminate is cured. More particularly, as shown in Fig. 3, a light irradiation capable of curing the photo-curable resin composition is irradiated downward to the transparent film 5 of the laminate in the direction of the arrow A in Fig. 3. The light irradiation is passed through the transparent film 5 and reaches the photo-curable resin composition, to cure the photo-curable resin composition, whereby the photo-curable resin composition layer 4a is changed to the cured resin layer 4b (see Fig. 3).

As a result, the laminate composed of the substrate film 1, the cured resin layer 4b containing the non-contact data carrier element 2, and the transparent film 5 is obtained. The photo-curable resin composition used in the present invention maintains a sufficient adhesiveness for the substrate film 1 after curing. Therefore, the cured resin layer 4b is in close contact with the substrate film 1, and the non-contact data carrier element 2 sandwiched therebetween is fully protected.

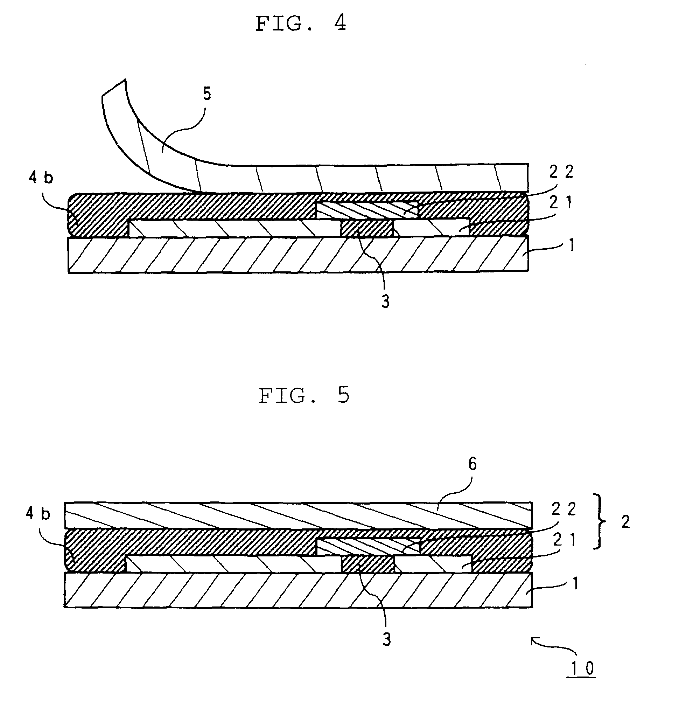

In the process of the present invention, a film which may be peeled from the cured resin layer 4b is used as the transparent film 5. As shown in Fig. 4, after the formation of the cured resin layer 4b, the transparent film 5 may be peeled therefrom, and then, as shown in Fig. 5, the cover film 6 may be laminated to the cured resin layer 4b to obtain the resin-sealed non-contact data carrier 10. When the substrate film 1 and the cover film 6 in the resulting resin-sealed non-contact data carrier 10 are opaque, an internal structure thereof is concealed from the outside. The cover film 6 may be printed to carry ornamental designs, before laminating. The printing procedure is easier in comparison with a printing after laminated.

The photo-curable resin composition used in the process of the present invention exhibits a low viscosity before being optically cured, but is changed to the cured resin having a high adhesiveness after having been optically cured.

The photo-curable resin composition having the above properties is composed of, for example, a curable component and a photopolymerization initiator. As the curable component, there may be mentioned, for example, an unsaturated polyester, a polyisoprene, a polybutadiene, a polyvinyl siloxane, an alkyl acrylate, an alkyl methacrylate, an acrylate modified phenol ethyleneoxide, an isobornyl acrylate, an acrylate modified bisphenolethyleneoxide, an acrylate modified ethyleneoxide isocyanarate, a tripropylene glycol diacrylate, a polyethylene glycol diacrylate, a pentaerythritol triacrylate, trimethylolpropane triacrylate, urethane acrylate, a polyester acylate, styrene, vinyl acetate, or vinyl pyrrolidone. The above curable component may be used singly, but in general several components may be combined to adjust the viscosity of a solution or properties of a cured product.

As the photopolymerization initiator, there may be mentioned, for example, a ketone, such as acetophenone, benzophenone, or Michler's ketone.

The photopolymerization initiator is preferably used in an amount of 0.5 to 10 parts by weight with respect to 100 parts by weight of the curable component. The photo-curable resin composition may optionally contain, in addition to the above ingredients, a resin compound, such as a poly (meth)acrylate, a saturated polyester, a polyether, a urethane resin, or a silicone resin, a filler, such as titanium oxide or silica, a tackifier, such as a rosin ester or a terpene resin, an antioxidant, or a light stabilizer, or the like.

The photo-curable resin composition may be prepared by mixing the above ingredients in any sequential order.

Before curing, the photo-curable resin composition used in the process of the present invention preferably has a viscosity such that the photo-curable resin composition can pour into and fill in the insides of depressed portions of the irregular or uneven structure formed by mounting the non-contact data carrier element on the surface of the substrate film. The viscosity as above is preferably 5000 mPa·s or less, more preferably 10 mPa·s to 5000 mPa·s. The photo-curable resin composition with the viscosity of 5000 mPa·s or less can thoroughly pour into and completely fill in the insides of the depressed portions. When the viscosity is 10 mPa·s or more, the shape retention and process condition are improved.

The substrate film and the transparent film may be coated with the photo-curable resin composition by any conventional method. When the substrate film is directly coated, care must be taken not to break the non-contact data carrier element. In the coating process, for example, a die coater, a knife coater or the like may be used.

The photo-curable resin composition may be cured by irradiation of, for example, a visible light, or preferably an ultraviolet light. The resulting cured resin must have adhere to the substrate film. The adhesiveness of the cured resin is preferably 0.5 N/25 mm or more, more preferably 0.5 N/25 mm to 100 N/25 m. The term "adhesiveness" as used herein means a value measured in accordance with a 180 degree peeling test in JIS (Japanese Industrial Standard) Z 0237, 8.3.1. If the adhesiveness is 0.5 N/25 mm or more, the cured resin is strongly bonded to the substrate film. The thickness of the cured resin layer is not particularly limited, but is preferably about 50 µm to 2 mm.

The substrate film which may be used in the process of the present invention is not particularly limited, so long as it serves as a support capable of stably holding the non-contact data carrier element not only during each step production, but also in the resin-sealed non-contact data carrier produced according to the process of the present invention. The substrate film may be transparent or opaque.

The substrate film may be, for example, a paper, a sheet of a natural or synthetic fibrous material, such as a woven fabric sheet, a knitted fabric sheet or a nonwoven fabric sheet, a synthetic resin film or sheet. As the synthetic resin, there may be mentioned, for example, a polyethylene, a polypropylene, a polyvinyl chloride, a polystyrene, a polyester such as a polyethylene terephthalate or a polyethylene naphthalate, a polyvinyl acetate, a polybutene, a polyacrylic acid, a polymethacrylic acid, a polyacrylate, a polymethacrylate, a polyvinyl alcohol, a polyvinyl formal, a polyvinyl butyral, a polyacrylonitrile, a polyimide, a polycarbonate, a polyamide, an ethylene-vinyl acetate copolymer, an ethylene acrylate copolymer, a polyvinyl acetal, an ethyl cellulose, a cellulose triacetate, a hydroxypropyl cellulose, or an acrylonitrile-butadiene-stylene copolymer, or the like. In many cases, an internal structure of the non-contact data carrier should be concealed, from a standpoint of design or security. In such a case, the substrate film is preferably opaque. The opaque substrate film may be prepared by a method wherein an opacifying agent, such as titanium oxide or calcium carbonate is incorporated to the film, a method wherein the film surface is coated or printed with the opacifying agent together with a binder, a method wherein a blowing agent is used, or a method wherein talc having a poor compatibility with the film or the like is incorporated to the film, and the film then drawn to form micropores in the film, or the like.

The thickness of the substrate film is not particularly limited, but is preferably 50 µm to 2 mm.

The transparent film which may be used in the process of the present invention is not particularly limited, so long as it can transmit the light capable of curing the photo-curable resin composition. As the transparent film, there may be mentioned, for example, a polyethylene film, a polypropylene film, a polyester film, or the like, or a film having a releasability imparted by coating the above film or a polyamide or polyvinyl chloride film with a silicone resin or a polymer of a long-chain aliphatic ester of (meth)acrylic acid. The thickness of the transparent film is not particularly limited, but is preferably 100 µm or less.

The cover film which may be used in the process of the present invention is not particularly limited, so long as it exhibits a sufficient adhesiveness to the cured resin. As the cover film, there may be mentioned, for example, a paper, or a film of a polyester such as a polyethylene terephthalate or a polyethylene naphthalate, or a polyvinyl chloride, a polyethylene, a polypropylene, or an ethylene vinyl acetate. The sheet or film may be used singly, or as a laminate composed thereof. In many cases, an internal structure of the non-contact data carrier should be concealed, from a standpoint of design or security. In such a case, the cover film is preferably opaque. The opaque cover film may be prepared by the same method as those used when preparing the opaque substrate film as above.

The cover film may be bonded to the cured resin by a method wherein the cover film is laminated after completing the curing step, a method wherein the cover film is laminated before completing the curing step, a method wherein the cover film is thermally bonded directly to the cured resin, or a method wherein a pressure-sensitive adhesive or a heat-sensitive adhesive is used. The thickness of the cover film is not particularly limited, but is preferably about 25 µm to 2 mm.

An ornamental design may be printed on the surface of the substrate film and/or the cover film by a conventional printer or the like.

According to the process of the present invention, a thin resin-sealed non-contact data carrier can be produced. For example, an antenna circuit having a thickness of about 35 µm is mounted on one surface of a substrate film (50 mm X 80 mm) having a thickness of about 75 µm. Then, an IC chip having a thickness of about 50 µm is placed on the antenna circuit. Thereafter, a cured resin layer having a thickness (i.e., an interval between the substrate film and the cover film) of about 100 µm is formed and a cover film having a thickness of about 75 µm is laminated thereto, to obtain a resin-sealed non-contact data carrier having a total thickness of about 250 µm. The surface of the cover film of the resulting resin-sealed non-contact data carrier is completely flat, and no affect due to an irregular or uneven internal structure is observed. The substrate film and the cover film are firmly laminated to each other, and do not separate from each other when the non-contact data carrier is used.

### Examples

The present invention will now be further illustrated by, but is by no means limited to, the following Examples.

### Preparation of photo-curable resin compositions and determination of properties thereof

Photo-curable resin compositions (A) to (D) composed of the following ingredients were prepared, and the viscosity (before curing) of each of the resulting photo-curable resin compositions (A) to (D) were measured, using a B-type viscometer at 25'C.

Thereafter, an adhesiveness (after curing) of each of the resulting photo-curable resin compositions (A) to (D) was measured in accordance with a 180 degree peeling test of JIS Z 0237, 8.3.1. More particularly, the photo-curable resin compositions (A) to (D) were applied on a polyethylene terephthalate (PET) film (thickness = 50 µm), using a doctor blade. The coated surface was irradiated with ultraviolet light (80W/cm²) from a mercury vapor lamp, to cure the composition. The thickness of the cured adhesive formed on the film was 50 µm. The resulting film was cut to a sample having a width of 25 mm and bonded to a polyethylene terephthalate (PET) plate (thickness = 2 mm). The sample was allowed to stand for 24 hours, and the adhesiveness upon peeling at 180 degree then measured. The composition, viscosity, and adhesiveness (after curing) of each of the photo-curable resin compositions (A) to (D) are shown as follows.
(1) Photo-curable resin composition (A):
   Polyester acrylate (38 g)
   Butyl acrylate (50 g)
   1-Hydroxy-cyclohexyl-phenyl ketone (2 g)
   Viscosity of resin at 25°C (before curing):830 mPa·s
   Adhesiveness to PET (after curing): 5 N/25 mm
(2) Photo-curable resin composition (B):
   Polyester acrylate (38 g)
   2-Hydroxy-3-phenoxypropyl acrylate (20 g)
   2-Ethylhexyl acrylate (40 g)
   1-Hydroxy-cyclohexyl-phenyl ketone (2 g)
   Viscosity of resin at 25°C (before curing) : 340 mPa·s
   Adhesiveness to PET (after curing): 4 N/25 mm
(3) Photo-curable resin composition (C):
   Urethane acrylate (30 g)
   2-Hydroxy-3-phenoxypropyl acrylate (48 g)
   1-Hydroxy-cyclohexyl-phenyl ketone (2 g)
   Viscosity of resin at 25°C (before curing): 1200 mPa·s
   Adhesiveness to PET (after curing): 13 N/25 mm
(4) Photo-curable resin composition (D):
   Urethane acrylate (50 g)
   2-Hydroxy-3-phenoxypropyl acrylate (38 g)
   2-Ethylhexyl acrylate (10 g)
   1-Hydroxy-cyclohexyl-phenyl ketone (2 g)
   Viscosity of resin at 25°C (before curing): 2300 mPa·s
   Adhesiveness to PET (after curing): 15 N/25 mm

### Example 1

A loop antenna circuit was punched from a copper foil (thickness = 30 µm), coated with a polyurethane adhesive (thickness = 5 µm), and bonded to a substrate of an opaque white polyethylene terephthalate film (thickness = 75 µm; Crisper G2323 TOYOBO CO., LTD.). A non-contact data carrier IC chip (thickness = 50 µm; driven at 13.56 MHz zone) was bonded to the antenna circuit with an electrically conductive adhesive, to form a non-contact data carrier element on the substrate.

The surface carrying the non-contact data carrier element on the substrate was coated with the photo-curable resin composition (A). As the transparent film, a polyethylene terephthalate film (thickness = 38 µm) having a releasability imparted by applying a silicone resin was laminated thereon so that the total thickness became about 210 µm. Ultraviolet light was applied thereto at 80W/cm² from a mercury vapor lamp, to cure the photo-curable resin composition.

Thereafter, the polyethylene terephthalate film having a releasability was peeled, and an opaque white polyethylene terephthalate film (thickness = 75 µm; Crisper G2323, TOYOBO CO., LTD.) was laminated as the cover film to obtain a resin-sealed non-contact data carrier (thickness = about 250 µm) according to the present invention.

### Example 2

The procedure disclosed in Example 1 was repeated, except that the photo-curable resin composition (B) was used instead of the photo-curable resin composition (A), to obtain a resin-sealed non-contact data carrier.

### Example 3

The procedure disclosed in Example 1 was repeated, except that the photo-curable resin composition (C) was used instead of the photo-curable resin composition (A), to obtain a resin-sealed non-contact data carrier.

### Example 4

The procedure disclosed in Example 1 was repeated, except that the photo-curable resin composition (D) was used instead of the photo-curable resin composition (A), to obtain a resin-sealed non-contact data carrier.

### Comparative Example 1

An opaque white polyethylene terephthalate film substrate carrying the non-contact data carrier element was prepared as in Example 1. Then, a thermoplastic resin (ethylene-vinyl acetate copolymer) film and an opaque white polyethylene terephthalate film (thickness = 75 µm; Crisper G2323, TOYOBO CO., LTD.) were laminated thereon, and the laminate was passed through heat rolls at 130°C, to obtain a resin-sealed non-contact data carrier.

### Comparative Example 2

An opaque white polyethylene terephthalate film substrate carrying the non-contact data carrier element was prepared as in Example 1. Then, the substrate plate was coated with a thermosetting resin composition (phenol resin). An opaque white polyethylene terephthalate film (thickness = 75 µm; Crisper G2323, TOYOBO CO., LTD.) was placed on the thermosetting resin composition layer. The resulting laminate was passed through heat rolls at 180°C, to obtain a resin-sealed non-contact data carrier.

### Evaluation of Properties

(1) Adhesiveness to polyethylene terephthalate (PET) plate An adhesiveness of the thermoplastic resin and the thermosetting resin used in Comparative Examples 1 and 2 was measured as follows: The thermoplastic resin film used in Comparative Example 1 was laminated on a polyethylene terephthalate (PET) film (thickness = 50 µm), and then the whole was laminated on a polyethylene terephthalate (PET) plate (thickness = 2 mm) under the same condition used in Comparative Example 1. A polyethylene terephthalate (PET) film (thickness = 50 µm) was coated with the thermosetting resin composition used in Comparative Example 2, and then the whole was laminated to a polyethylene terephthalate (PET) plate (thickness = 2 mm) under the same conditions used in Comparative Example 2. The thickness of each of the resins on the polyethylene terephthalate (PET) plate was 50 µm. The polyethylene terephthalate films carrying the resin were allowed to stand for 24 hours, and cut to a sample having a width of 25 mm. Thereafter, the adhesiveness upon peeling at 180 degree then measured. The results are shown in Table 1. For comparison, the results of Examples 1 to 4 are again listed.
(2) Surface state
Thicknesses of each of the resin-sealed non-contact data carriers prepared in Examples 1 to 4 and Comparative Examples 1 and 2 were measured at 20 points. The thicknesses were measured at the same points in each resin-sealed non-contact data carrier, using a thickness gauge. A difference between a maximum value and a minimum value was calculated for each resin-sealed non-contact data carrier. The results are shown in Table 1.
(3) Dispatching/receiving test
A dispatching test and a receiving test of the resin-sealed non-contact data carriers prepared in Examples 1 to 4 and Comparative Examples 1 and 2, were carried out five times respectively. The results are shown in Table 1, wherein a denominator denotes the total number of the tests (=5), and a numerator denotes the number where the dispatching test and a receiving test were conducted normally.
(4) Opacifying property of circuit
A surface of the cover film, i.e., the opaque white polyethylene terephthalate film, of each of the resin-sealed non-contact data carriers prepared in Examples 1 to 4 and Comparative Examples 1 and 2 was visually observed to evaluate an influence of the irregular or uneven structure due to the non-contact data carrier element. In Table 1, ○ means that no influence of the irregular or uneven structure was observed, whereas × means that an influence of the irregular or uneven structure was observed.

**Table 1**

| | Adhesiveness to PET plate (N/25 mm) | Surface state | Dispatching /receiving test | Opacifying property of circuit |
|---|---|---|---|---|
| Example 1 | 5 | 3µm | 5/5 | ○ |
| Example 2 | 4 | 5µm | 5/5 | ○ |
| Example 3 | 13 | 10µm | 5/5 | ○ |
| Example 4 | 15 | 8µm | 5/5 | ○ |
| Comparative Example 1 | 3 | 30 | 0/5 | × |
| Comparative Example 2 | 20 | 12 | 0/5 | ○ |

In the process of the present invention, the non-contact data carrier element can be completely covered without damage, with the resin composition having a low viscosity and a good pourability before curing, and the resin can be optically cured to thereby prevent the non-contact data carrier element from damage during the curing step. Further, the thin resin-sealed non-contact data carrier can be obtained while maintaining a smooth surface. When the opaque cover film is used, the thin resin-sealed non-contact data carrier having an excellent opacifying property can be obtained with a simple procedure. Further, the photo-curable resin composition is used, and thus the curing temperature is low. Therefore, a thin resin-sealed non-contact data carrier containing a built-in battery can be obtained without a liquid leakage from or a bursting of the battery.

## Claims

1. A process for producing a non-contact data carrier comprising the steps of:
(1) forming a laminate containing a substrate film [1], a non-contact data carrier element [2] mounted on one surface [la] of said substrate film [1], a photo-curable resin composition layer [4b] formed to cover a whole of said non-contact data carrier element [2], and a transparent film [5] covering said photo-curable resin composition layer [4b], said transparent film [5] being peelable from a cured resin layer [4b] formed by curing said photo-curable resin composition;
(2) irradiating said photo-curable resin composition with a light capable of curing said photo-curable resin composition through said transparent film [5] on said photo-curable resin composition layer [4a] to thereby cure said photo-curable resin composition, and form said cured resin layer [4b] embedding the whole of said non-contact data carrier element [2];
(3) peeling said transparent film [5] from said cured resin layer [4b]; and
(4) laminating a cover film [6] to said the cured resin layer [4b].

2. The process according to claim 1, wherein said step (1) comprises
(1a-1) coating the surface [la] of the substrate film [1] with the photo-curable resin composition to cover the whole non-contact data carrier element [2] therewith, whereby the photo-curable resin composition layer [4a] is formed; and then
(1a-2) laminating the transparent film [5] on the photo-curable resin composition layer [4a].

3. The process according to claim 1, wherein said step (1) comprises
(1b-1) coating the transparent film [5] with the photo-curable resin composition; and then
(1b-2) laminating the transparent film [5] on the surface [1a] of the substrate film [1] so that the whole non-contact data carrier element [2] is covered with the photo-curable resin composition on the transparent film [5].

4. The process according to any one of claims 1 to 3, wherein a viscosity of said photo-curable resin composition is 5000 mPa·s or less.

5. The process according to claim 4, wherein an adhesiveness of said cured resin formed by curing said photo-curable resin composition is 0.5 N/25 mm or more.
